# EUROPEAN PATENT SPECIFICATION

(11) **EP 3 553 809 B1**
(45) Date of publication and mention of the grant of the patent: **11.11.2026**
(21) Application number: 18212978.3
(22) Date of filing: 17.12.2018
(51) Int. Cl.: H10B 41/41, H10B 43/40, H10P 14/60, H10B 41/35

(54) **VERTICAL MEMORY DEVICES AND METHODS OF MANUFACTURING THE SAME**
VERTIKALE SPEICHERVORRICHTUNGEN UND VERFAHREN ZUR HERSTELLUNG DAVON
DISPOSITIFS DE MÉMOIRE VERTICAUX ET LEURS PROCÉDÉS DE FABRICATION

(30) Priority: 09.04.2018 KR 20180040936
(43) Date of publication of application: 16.10.2019
(73) Proprietor: Samsung Electronics Co., Ltd., Suwon-si, Gyeonggi-do, 16677 (KR)
(72) Inventor: CHEON, Ji-Sung, Gyeonggi-do (KR); BAEK, Seok-Cheon, Gyeonggi-do (KR)
(74) Representative: Kuhnen & Wacker Patent- und Rechtsanwaltsbüro PartG mbB

(56) References cited:
- US-A1- 2015 340 374
- US-A1- 2016 343 725
- US-A1- 2018 090 512
- MIN-CHUN TSAI: "A formula of STI cmp design rule", VLSI, ACM, 2 PENN PLAZA, SUITE 701 NEW YORK NY 10121-0701 USA, 4 May 2008 (2008-05-04), pages 11 - 16, XP058202065, ISBN: 978-1-59593-999-9, DOI: 10.1145/1366110.1366117

## Description

### BACKGROUND

### 1. Field

Example embodiments relate to vertical memory devices.

### 2. Description of the Related Art

Document US 2015/0340374 A1 discloses a method of manufacturing a memory device including: providing a substrate; forming in a cell region a channel extending in a direction perpendicular to an upper surface of the substrate and a plurality of gate electrode layers and a plurality of insulating layers stacked alternatingly on the substrate to be adjacent to the channel; forming a plurality of circuit elements on the substrate at a peripheral circuit region disposed at a periphery of the cell region; and forming an interlayer insulating layer on the substrate in the cell region and the peripheral circuit region, the interlayer insulating layer including a first, bottom interlayer insulating layer covering the plurality of circuit elements and at least a portion of the plurality of gate electrode layers, and a second, top interlayer insulating layer disposed on the first interlayer insulating layer.
US 2016/0343725 A1 shows a memory device including a cell region and a peripheral circuit region adjacent the cell region. A plurality of gate electrode layers and insulating layers are stacked on the substrate in the cell region, and a plurality of circuit devices are in the peripheral circuit region. A first interlayer insulating layer is on the substrate in the peripheral circuit region and covers the plurality of circuit devices, and a second interlayer insulating layer is on the substrate in the cell region and the peripheral circuit region. A blocking layer is on the plurality of circuit devices between the first and second interlayer insulating layers. The blocking layer is on an upper surface, of the first interlayer insulating layer, and a side surface of the blocking layer is covered by the second interlayer insulating layer.

MIN-CHUN TSAI: "A formula of STI cmp design rule", VLSI, ACM, 2 PENN PLAZA, SUITE 701 NEW YORK NY 10121-0701 USA, 4 May 2008 (2008-05-04), pages 11-16, XP058202065 shows that Chemical mechanical polishing (CMP) planarization in Shallow trench isolation (STI) is a key step enabling CMOS technology scaling. STI-CMP phenomena must be carefully studied before proposing correct design rules for "density" and dummy fill. STICMP planarization depends strongly on Layout pattern interactions with deposited fill-oxide topography and oxide-nitride slurry selectivity. For instance, polishing characteristics of HDP filloxide behaves differently from TEOS fill-oxide. Traditional design-rule and dummy-fill based on "pattern density" and weighted "effective pattern density" failed to describe those phenomena adequately. To address those issues, three developments are described in this paper. First deposited fill-oxide models were developed to describe films topographies. Second, a timedependent full-die STI-CMP simulator for detail simulations was developed. And then, a formula for design rule and dummy-fill was developed.

From US 2018/090 512 A1 a method of fabricating a three-dimensional semiconductor device is known. The method includes providing a substrate with a peripheral circuit region and a cell array region; forming a peripheral structure on the peripheral circuit region, and forming an electrode structure on the cell array region. The electrode structure includes a lower electrode, a lower insulating planarized layer on the lower electrode, and upper electrodes and upper insulating layers vertically and alternatingly stacked on the lower insulating planarized layer, and the lower insulating planarized layer may be extended to cover the peripheral structure on the peripheral circuit region. An upper insulating planarized layer is formed to cover the electrode structure and the lower insulating planarized layer on the peripheral circuit region.

In manufacturing a VNAND flash memory device on a substrate including a cell region and a peripheral circuit region, a gate structure may be formed on the peripheral circuit region and an insulating interlayer covering the gate structure may be formed on the cell region and the peripheral circuit region. The insulating interlayer may have a non-flat upper surface due to the gate structure, and thus a planarization process may be performed on the insulating interlayer. However, the upper surface of the insulating interlayer may be scratched on the cell region of the substrate during the planarization process, and the characteristics of the VNAND flash memory device may be deteriorated.

### SUMMARY

It is an object of the present invention to provide a vertical memory device having improved electrical characteristics.

This object is solved by a vertical memory device according to the independent claim of the present application. Further developments are subject matter of the dependent claims.

### BRIEF DESCRIPTION OF THE DRAWINGS

FIG. 1A is a cross-sectional view illustrating a vertical memory device in accordance with example embodiments, and FIG. 1B is an enlarged cross-sectional view of a region X in FIG. 1A;
FIGS. 2 to 12 are cross-sectional views illustrating a method of manufacturing a vertical memory device;
FIG. 13 is a cross-sectional view illustrating a vertical memory device in accordance with example embodiments;
FIG. 14 is a cross-sectional view illustrating a method of manufacturing a vertical memory device;
FIG. 15 is a cross-sectional view illustrating a vertical memory device in accordance with example embodiments; and
FIG. 16 is a cross-sectional view illustrating a vertical memory device.

### DESCRIPTION OF EMBODIMENTS

Vertical memory devices and methods of manufacturing the same in accordance with example embodiments will be described more fully hereinafter with reference to the accompanying drawings. Hereinafter, two directions intersecting with each other among horizontal directions substantially parallel to an upper surface of a substrate are defined as first and second directions, respectively, and a vertical direction substantially perpendicular to the upper surface of the substrate is defined as a third direction. In example embodiments, the first and second directions may be orthogonal to each other.

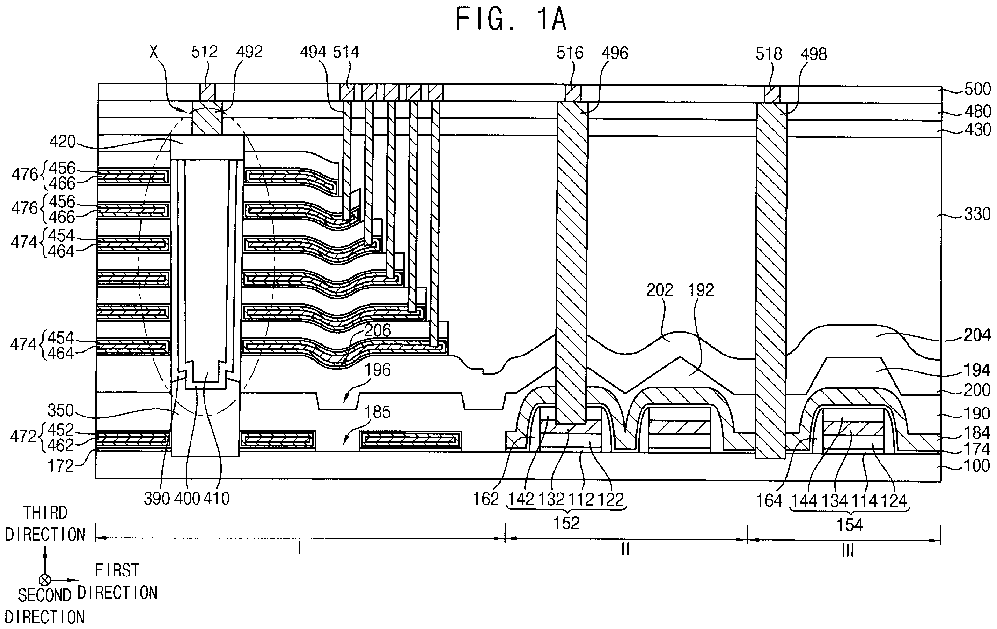

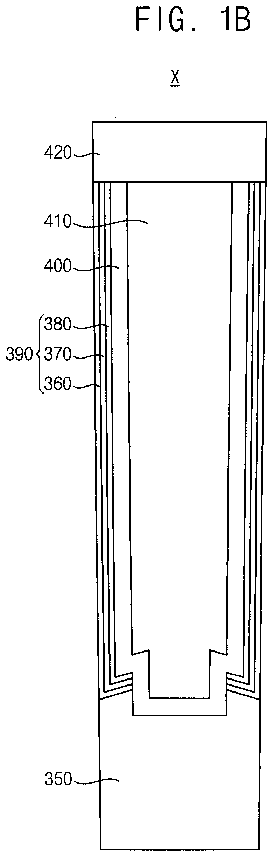

FIG. 1A is a cross-sectional view illustrating a vertical memory device in accordance with example embodiments, and FIG. 1B is an enlarged cross-sectional view of a region X in FIG. 1A.

Referring to FIG. 1A and FIG. 1B, the vertical memory device includes cell gate electrodes on a first region I of a substrate 100 including first to third regions I, II, and III, a second structure extending through the cell gate electrodes, first and second gate structures 152 and 154 on the second and third regions II and III, respectively, of the substrate 100, first to third insulation patterns 172, 174, and 325, an etch stop pattern 184, and/or first to sixth insulating interlayers 190, 200, 330, 430, 480, and 500.

The vertical memory device may further include first and second gate spacers 162 and 164, a second blocking layer 440, a common source line (CSL)(not shown), first to fourth contact plugs 492, 494, 496, and 498, and/or first to fourth wirings 512, 514, 516, and 518.

The substrate 100 may include semiconductor materials e.g., silicon, germanium, silicon-germanium, etc., or III-V compounds e.g., GaP, GaAs, GaSb, etc. In some example embodiments, the substrate 100 may be a silicon-on-insulator (SOI) substrate or a germanium-on-insulator (GOI) substrate.

In example embodiments, the first region I of the substrate 100 is a cell region where memory cells are formed, and the second and third regions II and III of the substrate 100 are a peripheral circuit region where X-decoders, page buffers, Y-decoders, driving circuits, etc. may be formed. Hereinafter, however, in the peripheral region, a region where the gate structures are formed relatively densely is referred to as the second region II, and a region where the gate structures are formed relatively sparsely is referred to as the third region III.

The first gate structure 152 on the second region II of the substrate 100 may include a first gate insulation pattern 112, a first polysilicon pattern 122, a first metal pattern 132, and/or a first gate mask 142 sequentially stacked, and the second gate structure 154 on the third region III of the substrate 100 includes a second gate insulation pattern 114, a second polysilicon pattern 124, a second metal pattern 134, and/or a second gate mask 144 sequentially stacked. The first polysilicon pattern 122 together with the first metal pattern 132 are referred to as a first gate electrode, and the second polysilicon pattern 124 together with the second metal pattern 134 are referred to as a second gate electrode. The first and second gate spacers 162 and 164 may be formed on sidewalls of the first and second gate structures 152 and 154, respectively.

The first and second gate insulation patterns 112 and 114 may include an oxide, e.g., silicon oxide, the first and second polysilicon patterns 122 and 124 may include polysilicon doped with p-type impurities or n-type impurities, the first and second metal patterns 132 and 134 may include a metal, e.g., tungsten, tantalum, titanium, etc., and the first and second gate masks may include an oxide, e.g., silicon oxide. The first and second gate spacers 162 and 164 may include an oxide, e.g., silicon oxide, and thus may be merged with the first and second gate masks 142 and 144, respectively.

In example embodiments, the first insulation pattern 172 may have a rectangular shape on the first region I of the substrate 100 in a plan view, and the second insulation pattern 174 and the etch stop pattern 184 may cover the first and second gate structures 152 and 154 and the first and second gate spacers 162 and 164 on the second and third regions II and III of the substrate 100 in a plan view. However, a first opening 185 partially exposing an upper surface of the substrate 100 may be formed through a third gate electrode 472 of the cell gate electrodes and the first insulation pattern 172 thereunder. In example embodiments, a plurality of first openings 185 may be formed to be spaced apart from each other in the second direction.

The first and second insulation patterns 172 and 174 may include an oxide, e.g., silicon oxide, and thus the second insulation pattern 174 may be merged with the first and second gate masks 142 and 144 and/or the first and second gate spacers 162 and 164. The etch stop pattern 184 may include a nitride, e.g., silicon nitride.

The first insulating interlayer 190 may be formed on the first to third regions I, II, and III of the substrate 100 to cover the first and second insulation patterns 172 and 174, the third gate electrode 472, and the etch stop pattern 184, and the second insulating interlayer 200 may be formed on the first insulating interlayer 190.

Each of the first and second insulating interlayers 190 and 200 may include silicon oxide. In example embodiments, the first and second insulating interlayers 190 and 200 may include different materials from each other. For example, the first insulating interlayer 190 may have high-density plasma (HDP) oxide, and the second insulating interlayer 200 may have tetraethyl orthosilicate (TEOS).

An upper surface of the first insulating interlayer 190 may not be flat due to the first and second gate structures 152 and 154 on the second and third regions II and III, respectively, of the substrate 100. That is, portions of the first insulating interlayer 190 on the first and second gate structures 152 and 154 may upwardly protrude when compared to other portions thereof.

In example embodiments, an upper surface of at least a portion of the first insulating interlayer 190 on the second and third regions II and III of the substrate 100 may have a cross-section in one direction, e.g., in the first direction with a shape of an angular protrusion and depression.

For example, upper surfaces of portions of the first insulating interlayer 190 on the first and second gate structures 152 and 154, that is, upper surfaces of first and second portions 192 and 194 of the first insulating interlayer 190 overlapping the first and second gate structures 152 and 154, respectively, in the third direction may have cross-sections in the first direction having a shape of a portion of a polygon. In one embodiment, the upper surface of the first portion 192 of the first insulating interlayer 190 overlapping the first gate structures 152 in the first direction, which may be arranged relatively densely, may have a cross-section with a shape of a portion of a triangle (including two sides neighboring with each other at an obtuse or acute angle), and the upper surface of the second portion 194 of the first insulating interlayer 190 overlapping the second gate structures 154 in the first direction, which may be arranged relatively sparsely, may have a cross-section with a shape of a portion of a rectangle or a hexagon (including three sides neighboring with each other at an obtuse angle).

A first concave portion 196 may be formed on the upper surface of the first insulating interlayer 190 on the first region I of the substrate 100, which may correspond to the first opening 185 through the first insulation pattern 172 and the third gate electrode 472. That is, the first concave portion 196 of the upper surface of the first insulating interlayer 190 over the first opening 185 may have a relatively short distance from the upper surface of the substrate 100 when compared to other portions of the upper surfaces of the first insulating interlayer 190 on the first region I of the substrate 100.

In example embodiments, the first concave portion 196 on the upper surface of the first insulating interlayer 190 may have a cross-section in the first direction with a shape of a portion of a polygon (including three sides neighboring with each other at an obtuse angle).

An upper surface of the second insulating interlayer 200 may have a shape corresponding to the shape of the upper surface of the first insulating interlayer 190. Thus, portions of the second insulating interlayer 200, which are formed on the first and second gate structures on the second and third regions II and III of the substrate 100, may upwardly protrude when compared to other portions thereof. However, unlike the cross-section of the upper surface of the first insulating interlayer 190, the cross-section of the upper surface of the second insulating interlayer 200 may have a smoothly curved shape instead of an angular protrusion and depression shape. That is, upper surfaces of third and fourth portions 202 and 204 of the second insulating interlayer 200 overlapping the first and second gate structures 152 and 154, respectively, in the third direction may have a cross-section in the first direction with a rounded curve shape corresponding to a portion of a polygon.

A second concave portion 206 is formed on the upper surface of the second insulating interlayer 200 on the first region I of the substrate 100, which may correspond to the first opening 185 through the first insulation pattern 172 and the third gate electrode 472. That is, the second concave portion 206 of the upper surface of the second insulating interlayer 200 may overlap the first concave portion 196 of the first insulating interlayer 190 in the third direction, but may have a cross-section in the first direction with a rounded concave shape corresponding to that of the first concave portion 196.

A mold of a staircase shape including a plurality of steps, each of which may include a fourth gate electrode 474 and the third insulation pattern 325 thereon or a fifth gate electrode 476 and the third insulation pattern 325 thereon, may be formed on the second insulating interlayer 200 on the first region I of the substrate 100, and the third insulating interlayer 330 may cover a sidewall and an upper surface of the mold.

In example embodiments, the steps included in the mold may have areas gradually decreasing at a constant rate from a lowermost one toward an uppermost one thereof. The lowest one of the steps in the mold may have a smaller area than one of the steps including the first insulation pattern 172 and the third gate electrode 472 in a plan view.

An upper surface of the third insulating interlayer 330 may be substantially flat without irregularities unlike the upper surface of the second insulating interlayer 200. The third insulating interlayer 330 may include a silicon oxide, e.g., TEOS, and thus may be merged with the underlying second insulating interlayer 200.

Each of the cell gate electrodes may extend in the first direction, and a plurality of cell gate electrodes may be formed in the second direction. That is, the cell gate electrodes each extending in the first direction may be spaced apart from each other by a second opening (not shown) extending in the first direction.

An end portion of each of the cell gate electrodes in the first direction may be referred to as a pad. The cell gate electrodes may be stacked at a plurality of levels, respectively, to be spaced apart from each other in the third direction, and the cell gate electrodes of each level may extend in the first direction on the first region I of the substrate 100. Lengths of the cell gate electrodes at the plurality of levels, respectively, may gradually decrease from a lowermost one toward an uppermost one thereof, and thus the cell gate electrodes may have a staircase shape as a whole.

The cell gate electrodes include the third to fifth gate electrodes 472, 474, and 476 sequentially stacked in the third direction. The third gate electrode 472 may serve as a ground selection line (GSL), the fourth gate electrode 474 may serve as a word line, and the fifth gate electrode 476 may serve as a string selection line (SSL).

The third gate electrode 472 may be formed at a lowest level and may be covered with the first insulating interlayer 190, and the fourth and fifth gate electrodes 474 and 476 may be formed at one or a plurality of levels on the second insulating interlayer 200. In example embodiments, the fifth gate electrode 486 may be formed at an uppermost level and one level thereunder, and the fourth gate electrode 474 may be formed at plurality of levels between the third gate electrode 472 and fifth gate electrode 476.

In example embodiments, the third gate electrodes 472 may be separated with each other in the second direction by the first opening 185 described above. Portions of the fourth and fifth gate electrodes 474 and 476 overlapping the first opening 185 in the third direction may have an upwardly concave shape. Unlike the angular shape of the first concave portion 196 of the upper surface of the portion of the first insulating interlayer 190 overlapping the first opening 185 in the third direction, the second concave portion 206 of the upper surface of the second insulating interlayer 200 may have a rounded shape, so that the portions of the fourth and fifth gate electrodes 474 and 476 on the second insulating interlayer 200 may also have not a rapidly concave shape but a gently concave shape. Accordingly, a phenomenon in which an electric field is concentrated on the above portions of the fourth and fifth gate electrodes 474 and 476 may be alleviated.

The third gate electrode 472 may include a third gate conductive pattern 462 and a third gate barrier pattern 452 covering upper and lower surfaces and a portion of a sidewall thereof, the fourth gate electrode 474 may include a fourth gate conductive pattern 464 and a fourth gate barrier pattern 454 covering upper and lower surfaces and a portion of a sidewall thereof, and the fifth gate electrode 476 may include a fifth gate conductive pattern 466 and covering upper and lower surfaces and a portion of a sidewall thereof.

Each of the third to fifth gate conductive patterns 462, 464 and 466 may include a low resistance metal, e.g., tungsten, titanium, tantalum, platinum, etc., and each of the third to fifth gate barrier patterns may include a metal nitride, e.g., titanium nitride, tantalum nitride, etc. Alternatively, each of the third to fifth gate conductive patterns 462, 464 and 466 may include a first layer including a metal and a second layer including a metal nitride.

The second structure may extend through the cell gate electrodes. The second structure may include an epitaxial layer 350, a first structure, and a capping pattern 420 sequentially stacked on the first region I of the substrate 100.

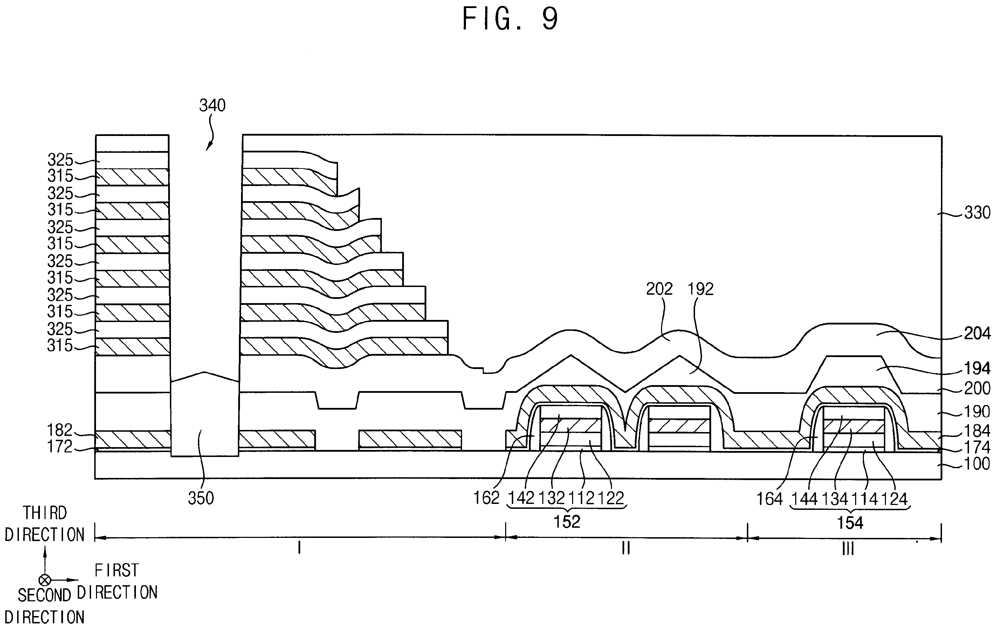

The epitaxial layer 350 may fill a lower portion of a channel hole 340 (refer to FIG. 9) extending through the first insulation pattern 172, the third gate electrode 472, the first and second insulating interlayers 190 and 200, the fourth and fifth gate electrodes 474 and 476, the third insulation pattern 325 and the third insulating interlayer 330, and exposing the first region I of the substrate 100, and may contact the upper surface of the substrate 100. The channel hole 340 may be formed on the first region I of the substrate 100 in each of the first and second directions to form a plurality of channel hole arrays.

In example embodiments, the epitaxial layer 350 may include single crystalline silicon, and a height of an upper surface thereof may be higher than a lower surface of the first insulating interlayer 190 and lower than the upper surface of the second insulating interlayer 200.

The first structure may be formed on the epitaxial layer 350 in the channel hole 340, and may include a channel 400, a charge storage structure 390 covering an outer sidewall of the channel 400, and a filling pattern 410 filling a space formed by an inner wall of the channel 400 and contacting the upper surface of the epitaxial layer 350.

In example embodiments, the channel 400 may have a cup-like shape, the charge storage structure 390 may have a cup-like shape of which a central lower surface is opened, and the filling pattern 410 may have a pillar shape.

As the channel holes 340 in which the channels 400 are formed may form the channel hole arrays, the channels 400 may also form channel arrays corresponding thereto. The epitaxial layer 350 under the channel 400 may be referred to as a lower channel, and channel 400 may be referred to as an upper channel.

The channel 400 may include doped or undoped polysilicon or single crystalline silicon, and the filling pattern 410 may include an oxide, e.g., silicon oxide.

The charge storage structure 290 may include a tunnel insulation pattern 380, a charge storage pattern 370 and a first blocking pattern 360 sequentially stacked in the horizontal direction from the outer sidewall of the channel 400. Each of the tunnel insulation pattern 380 and the first blocking pattern 360 may include an oxide, e.g., silicon oxide, and the charge storage pattern 370 may include a nitride, e.g., silicon nitride.

The capping pattern 420 may be formed on the first structure in the channel hole 340. The capping pattern 420 may include doped or undoped polysilicon or single crystalline silicon.

In example embodiments, the epitaxial layer 350 may extend through the third gate electrode 472, and the channel 400 may extend through the fourth and fifth gate electrodes 474 and 476. Accordingly, the epitaxial layer 350 may extend through the third gate electrode 472, and may serve as a channel of a ground selection transistor (GST) including the third gate electrode 472. The channel 400 may extend through the fourth and fifth gate electrodes 474 and 476, and may serve as a channel of a string selection transistor (SST) including the fourth and fifth gate electrodes 474 and 476.

The third insulation pattern 325 may be formed between the fourth and fifth gate electrodes 474 and 476 arranged in the third direction, and on an uppermost one of the fifth gate electrodes 476. The third insulation pattern 325 may include a silicon oxide, e.g., TEOS, high density plasma (HDP) oxide, plasma enhanced oxide (PEOX), etc.

The fourth to sixth insulating interlayers 430, 480 and 500 may be formed on the third insulating interlayer 330, and may include an oxide, e.g., silicon oxide. Accordingly, the fourth to sixth insulating interlayers 430, 480 and 500 may be merged with each other, and/or may be merged with the underlying third insulating interlayer 330.

Each of the third to fifth gate electrodes 472, 474 and 476 may be surrounded by the second blocking layer 440. Thus, an outer sidewall of the charge storage structure 390 or a sidewall of the epitaxial layer 350 may contact the second blocking layer 440. The second blocking layer 440 may include a metal oxide, e.g., aluminum oxide, hafnium oxide, lanthanum oxide, lanthanum aluminum oxide, lanthanum hafnium oxide, hafnium aluminum oxide, titanium oxide, tantalum oxide, zirconium oxide, etc.

A common source line (CSL)(not shown) and a second spacer (not shown) covering a sidewall of the CSL may be formed in the second opening separating the plurality of cell gate electrodes, each of which may extend in the first direction, from each other in the second direction,. The CSL may include a metal, a metal nitride, etc., and the second spacer may include an insulating material, e.g., silicon oxide, silicon nitride, etc.

The first contact plug 492 may extend through the fourth and fifth insulating interlayers 430 and 480 to contact an upper surface of the capping pattern 420, the second contact plug 494 may extend through the third to fifth insulating interlayers 330, 430 and 480, the third insulation pattern 325, the second blocking layer 440 and fourth and fifth gate barrier pattern 454 and 456 to contact each of upper surfaces of the fourth and fifth gate conductive patterns 464 and 466, or may extend through the first to fifth insulating interlayers 190, 200, 330, 430 and 480, the second blocking layer 440 and the third gate barrier pattern 452 to contact an upper surface of the third gate conductive pattern 462. The second contact plug 494 may be formed on each of the pads having a staircase shape. That is, the second contact plug 494 may be formed on a portion of each pad not covered by upper pads.

The third contact plug 496 may extend through the first to fifth insulating interlayers 190, 200, 330, 430 and 480, the etch stop pattern 184, the second insulation pattern 174 and the first gate mask 142 to contact an upper surface of a first metal pattern 132, and the fourth contact plug may extend through the first to fifth insulating interlayers 190, 200, 330, 430 and 480, the etch stop pattern 184 and the second insulation pattern 174 to contact the upper surface of the substrate 100.

The first to fourth wirings 512, 514, 516 and 518 may contact upper surfaces of the first to fourth contact plugs 492, 494, 496 and 498, respectively. In example embodiments, the first wiring 512 may extend in the second direction, and may serve as a bit line of the vertical memory device.

The first to fourth contact plugs 492, 494, 496 and 498 and the first to fourth wirings 512, 514, 516 and 518 may include a metal, e.g., tungsten, titanium, tantalum, etc., and/or a metal nitride, e.g., titanium nitride, tantalum nitride, tungsten nitride, etc.

As described above, the first and second insulating interlayers 190 and 200 on the second and third regions II and III of the substrate 100 may cover the first and second gate structures 152 and 154, and thus the cross-sections of the upper surfaces of the first and second insulating interlayers 190 and 200 may have a protrusion and depression shape, while the third insulating interlayer 330 on the second insulating interlayer 200 may have a flat upper surface. The protrusion and depression shape of the upper surface of the first insulating interlayer 190 may be a portion of a polygon at least partially angular, however, the protrusion and depression shape of the upper surface of the second insulating interlayer 200 may have be rounded.

The two insulating interlayers 190 and 200 may be formed between the third gate electrode 472 serving as a GSL and the fourth gate electrode 474 serving as a word line on the first region I of the substrate 100, and may include different materials from each other.

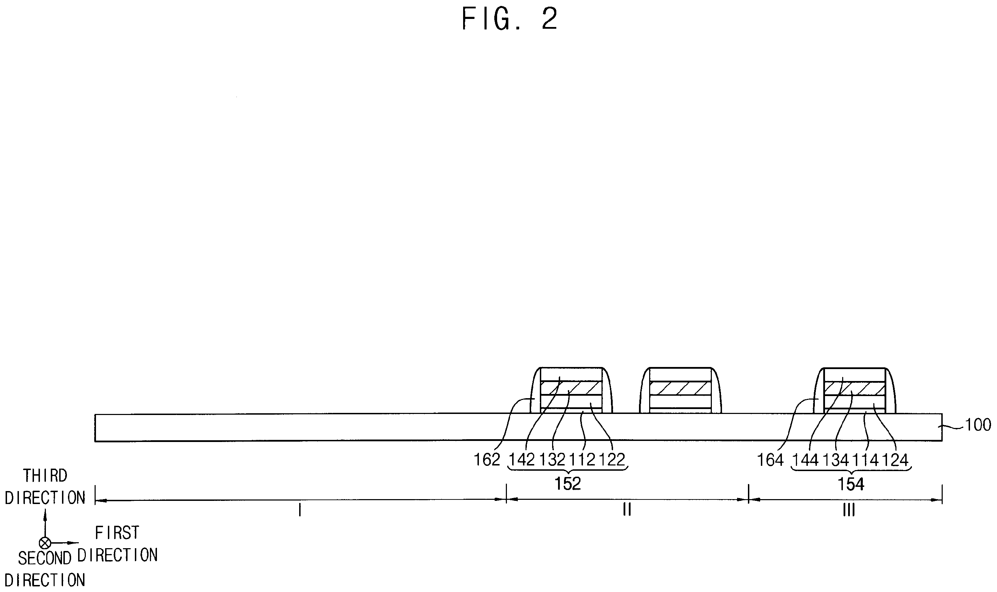

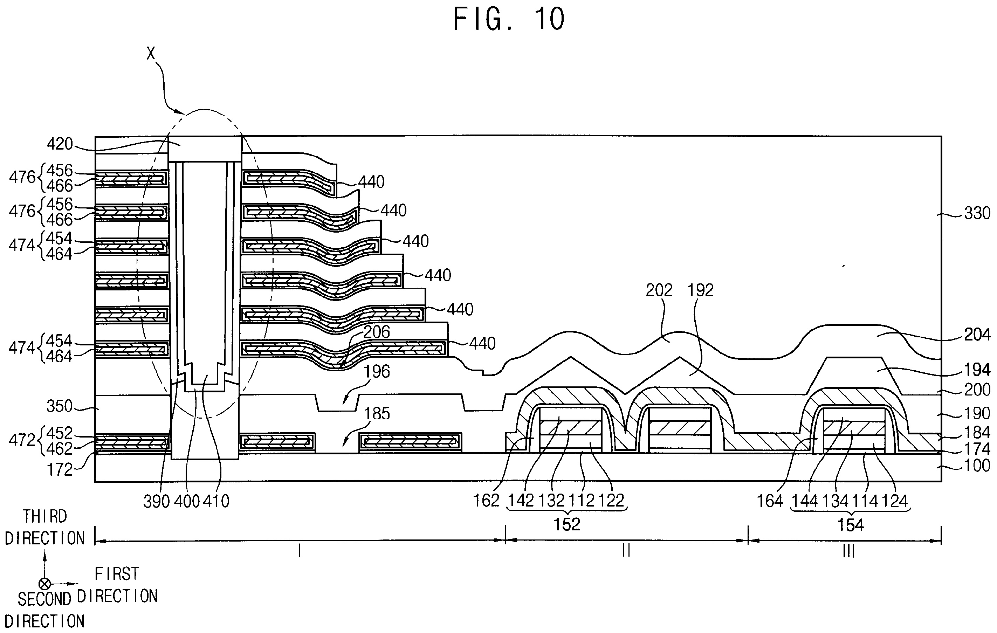

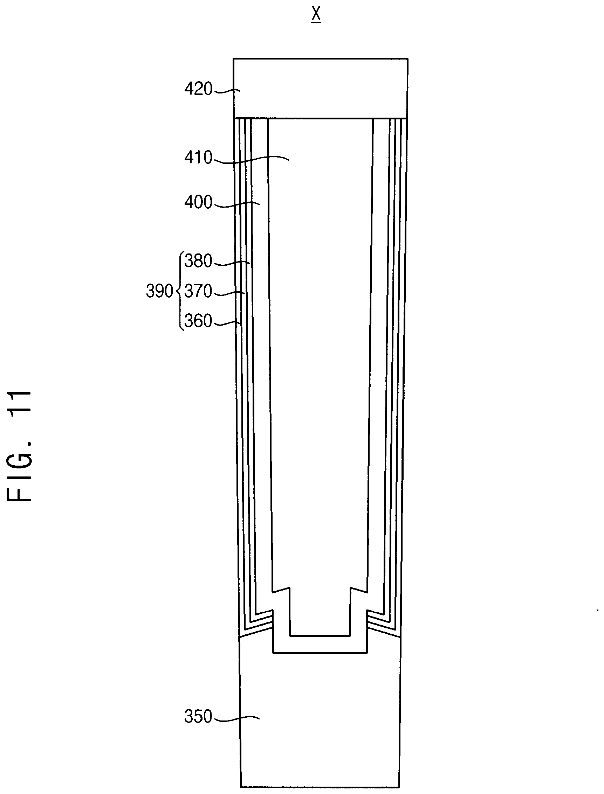

FIGS. 2 to 12 are cross-sectional views illustrating a method of manufacturing a vertical memory device in accordance with example embodiments. FIG. 11 is an enlarged cross-sectional view of a region X in FIG. 10.

Referring to FIG. 2, first and second gate structures 152 and 154 may be formed on second and third regions II and III, respectively, of a substrate 100 including a first region I and the second and third regions II and III.

A gate insulation layer, a polysilicon layer, a metal layer, and a gate mask layer may be sequentially stacked on the substrate 100, and may be patterned to form the first and second gate structures 152 and 154. The first gate structure 152 may include a first gate insulation pattern 112, a first polysilicon pattern 122, a first metal pattern 132, and a first gate mask 142 sequentially stacked, and the second gate structure 154 may include a second gate insulation pattern 114, a second polysilicon pattern 124, a second metal pattern 134, and a second gate mask 144 sequentially stacked.

First and second gate spacers 162 and 164 may be formed on sidewalls of the first and second gate structures 152 and 154, respectively. A gate spacer layer covering the first and second gate structures 152 and 154 may be formed on the substrate 100, and may be anisotropically etched to form the first and second gate spacers 162 and 164. The first and second gate spacers 162 and 164 may be formed to include an oxide, e.g., silicon oxide, and thus may be merged with the first and second gate masks 142 and 144.

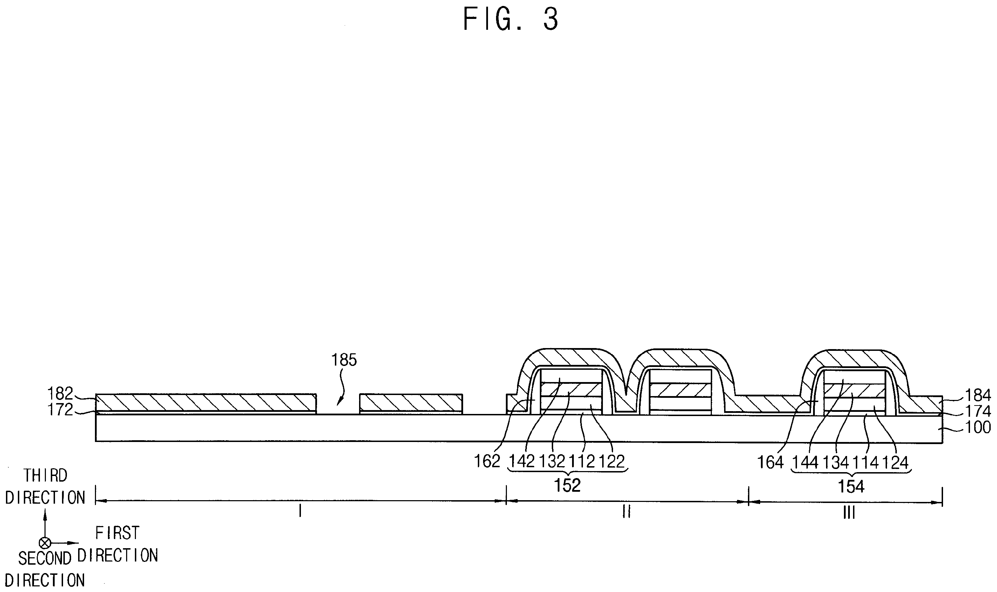

Referring to FIG. 3, a first insulation layer and an etch stop layer may be formed on the substrate 100 to cover the first and second gate structures 152 and 154, and may be patterned to form a first insulation pattern 172 and a first sacrificial pattern 182, respectively, sequentially stacked on the first region I of the substrate 100 and a second insulation pattern 174 and an etch stop pattern 184, respectively, sequentially stacked on the second region II of the substrate 100.

In example embodiments, the first insulation pattern 172 and the first sacrificial pattern 182 may have a rectangular shape on the first region I of the substrate 100 in a plan view, and the second insulation pattern 174 and the etch stop pattern 184 may cover the first and second gate structures 152 and 154 and the first and second gate spacers 162 and 164 on the second and third regions II and III of the substrate 100 in a plan view. However, a first opening 185 partially exposing an upper surface of the substrate 100 may be formed through the first insulation pattern 172 and the first sacrificial pattern 182. In example embodiments, a plurality of first openings 185 may be formed to be spaced apart from each other in the second direction.

The first insulation layer may include an oxide, e.g., silicon oxide, and thus may be merged with the first and second gate masks 142 and 144 and/or the first and second gate spacers 162 and 164.

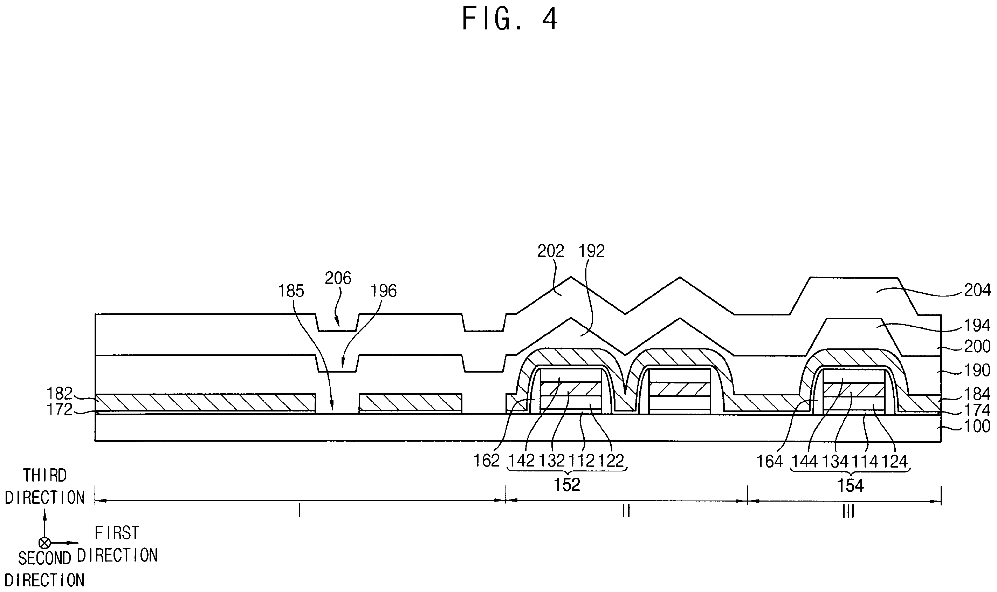

Referring to FIG. 4, a first insulating interlayer 190 covering the first and second insulation patterns 172 and 174, the first sacrificial pattern 182 and the etch stop pattern 184 may be formed on the substrate 100, and a second insulating interlayer 200 may be formed on the first insulating interlayer 190.

Each of the first and second insulating interlayers 190 and 200 may include a silicon oxide. In example embodiments, the first and second insulating interlayers 190 and 200 may include different materials from each other. For example, the first insulating interlayer 190 may be formed to include high density plasma (HDP) oxide, and the second insulating interlayer 200 may be formed to include TEOS.

The first insulating interlayer 190 may have a non-flat upper surface due to the first and second gate structures 152 and 154 on the second and third regions II and III of the substrate 100. That is, a portion of the first insulating interlayer 190 on the first and second gate structures 152 and 154 may have an upwardly protruding shape when compared to other portions thereof.

In example embodiments, an upper surface of at least a portion of the first insulating interlayer 190 on the second and third regions II and III of the substrate 100 may have a cross-section in one direction, for example, in the first direction, which may have an angular protrusion and depression shape.

A first concave portion 196 is formed on the upper surface of the first insulating interlayer 190, corresponding to the first opening 185 through the first insulation pattern 172 and the first sacrificial pattern 182 on the first region I of the substrate 100. In example embodiments, a cross-section in the first direction of the first concave portion 196 on the upper surface of the first insulating interlayer 190 has a shape of a portion of a polygon (including three sides neighboring with each other at an obtuse angle).

An upper surface of the second insulating interlayer 200 may have a shape corresponding to the shape of the upper surface of the first insulating interlayer 190. Thus, portions of the second insulating interlayer 200, which may be formed on the first and second gate structures 152 and 154 on the second and third regions II and III of the substrate 100, may upwardly protrude when compared to other portions thereof. In example embodiments, a cross-section of an upper surface of at least a portion of the second insulating interlayer 200 may have an angular protrusion and depression shape, and upper surfaces of third and fourth portions 202 and 204 of the second insulating interlayer 200 overlapping the first and second gate structures 152 and 154, respectively, in the third direction may have a cross-section in the first direction with a shape of a portion of a polygon.

The upper surface of the second insulating interlayer 200 also has a second concave portion 206 corresponding to the first opening 185 through the first insulation pattern 172 and the first sacrificial pattern 182 on the first region I of the substrate 100. That is, the second concave portion 206 on the upper surface of the second insulating interlayer 200 may be formed to overlap the first concave portion 196 on the upper surface of the first insulating interlayer 190 in the third direction, and may have a cross-section in the first direction with a shape of a portion of a polygon (including three sides neighboring with each other at an obtuse angle).

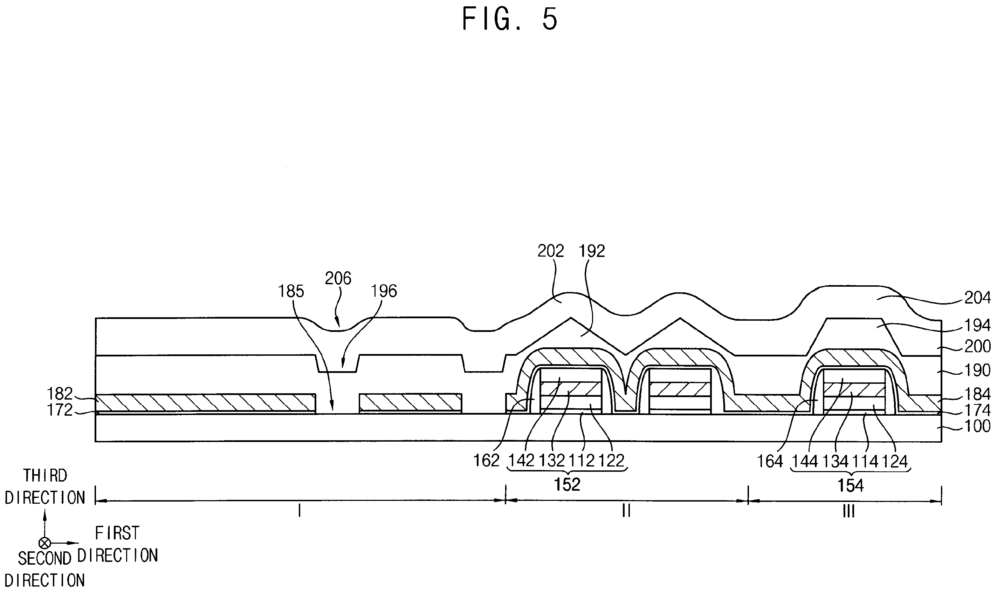

Referring to FIG. 5, a wet etching process may be performed on the upper surface of the second insulating interlayer 200, so that the second concave portion 206 on the first region I of the substrate 100 may have a smoothly curved surface.

That is, the shape of the cross-section in the first direction of the second concave portion 206 on the upper surface of the second insulating interlayer 200, which may be a shape of a portion of a polygon, may be transformed into a rounded concave shape by the wet etching process.

The shapes of the cross-sections in the first direction of the upper surfaces of the third and fourth portions 202 and 204 of the second insulating interlayer 200 on the second and third regions II and III of the substrate 100 may be transformed into a rounded convex shape by the wet etching process.

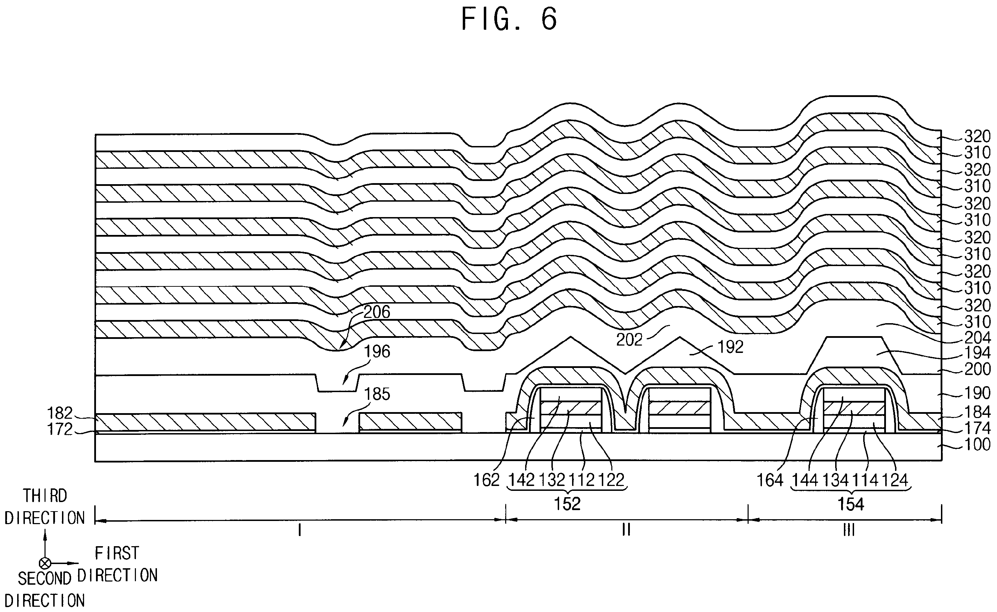

Referring to FIG. 6, a sacrificial layer 310 and a second insulation layer 320 may be alternately and repeatedly stacked on the second insulating interlayer 200. Accordingly, a plurality of sacrificial layers 310 and a plurality of second insulation layers 320 may be alternately stacked in the third direction. FIG. 6 shows the sacrificial layers 310 at six levels, respectively, and the second insulation layers 320 at six levels, respectively. However, the numbers of the sacrificial layers 310 and the second insulation layers 320 may not be limited thereto, and may be more or less than 6, respectively.

Each of the sacrificial layer 310 and the second insulation layer 320 may be formed to have a partially curved shape corresponding to the protrusion and depression shape of the upper surface of the second insulating interlayer 200 or the second concave portion 206.

The sacrificial layer 310 and the second insulation layer 320 may be formed by a process, e.g., a chemical vapor deposition (CVD) process, a plasma enhanced chemical vapor deposition (PECVD) process, an atomic layer deposition (ALD) process, etc.

The second insulation layer 320 may include a silicon oxide, e.g., TEOS, high density plasma (HDP) oxide, PEOX, etc., and the sacrificial layer 310 may include a material having an etching selectivity with respect to the second insulation layer 320, e.g., silicon nitride.

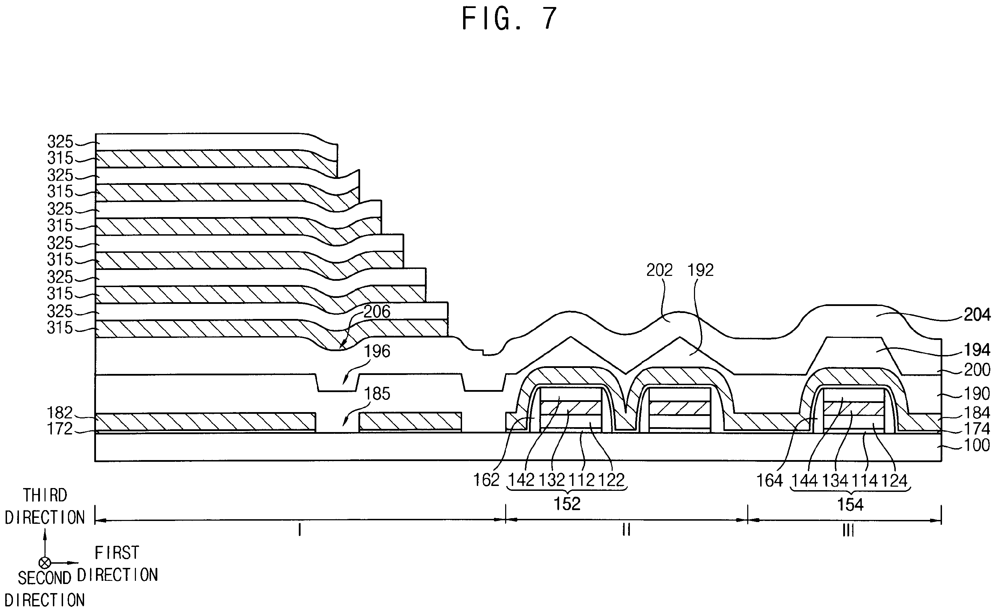

Referring to FIG. 7, a photoresist pattern (not shown) partially covering an uppermost one of the second insulation layers 320 may be formed on the uppermost one of the second insulation layers 320, and the uppermost one of the second insulation layers 320 and an uppermost one of the sacrificial layers 310 thereunder may be etched using the photoresist pattern as an etching mask. Accordingly, a portion of one of the second insulation layers 320 under the uppermost one of the sacrificial layers 310 may be exposed. After reducing a size of an area of the photoresist pattern by a given ratio, a trimming process in which the uppermost one of the second insulation layers 320, the uppermost one of the sacrificial layers 310, the exposed one of the second insulation layers 320 and one of the sacrificial layers 310 thereunder may be etched using the reduced photoresist pattern as an etching mask, may be performed. As the trimming process is repeatedly performed, a mold of a staircase shape including a plurality of steps each of which may include a second sacrificial pattern 315 and a third insulation pattern 325 sequentially stacked may be formed on the first region I of the substrate 100, and the upper surface of the second insulating interlayer 200 may be exposed on the second region II of the substrate 100.

In example embodiments, the steps included in the mold may have areas gradually decreasing at a constant ratio from a lowermost one toward an uppermost one thereof. The lowest one of the steps in the mold may have a smaller area than one of the steps including the first insulation pattern 172 and the first sacrificial pattern 182 in a plan view.

The mold may be formed by etching the sacrificial layer 310 and the second insulation layer 320 on the second insulating interlayer 200, so that no residue of the mold may remain on a boundary between the second and third regions II and III and the first region I of the substrate 100.

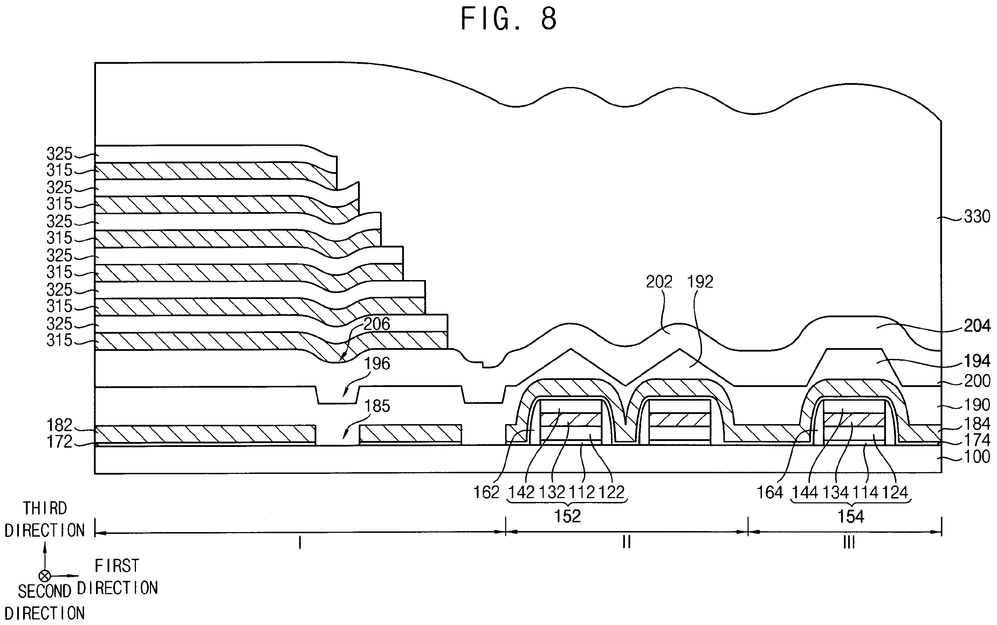

Referring to FIG. 8, a third insulating interlayer 330 covering the mold may be formed on the second insulating interlayer 200.

An upper surface of a portion of the third insulating interlayer 330 on the second and third regions II and III of the substrate 100 may have a protrusion and depression shape corresponding to that of the upper surface of the second insulating interlayer 200. The third insulating interlayer 330 may include a silicon oxide, e.g., TEOS, and thus may be merged with the underlying second insulating interlayer 200.

Referring to FIG. 9, a planarization process may be performed on an upper surface of the third insulating interlayer 330, and thus the upper surface of the third insulating interlayer 330 may become flat on the first to third regions I, II and III of the substrate 100.

The planarization process may include a chemical mechanical polishing (CMP) process and/or an etch back process, and may be performed until an upper surface of the uppermost one of the third insulation patterns 325 is exposed, or to a height higher than the upper surface of the uppermost one of the third insulation patterns 325.

A first mask (not shown) may be formed on the third insulating interlayer 330, and an etching process using the first mask as an etching mask may be performed on the third insulating interlayer 330, the third insulation patterns 325, the second sacrificial patterns 315, the second insulating interlayer 200, the first insulating interlayer 190, the first sacrificial pattern 182, and the first insulation pattern 172 to form a channel hole 340 therethrough, which may expose the first region I of the substrate 100.

A plurality of channel holes 340 may be formed in each of the first and second directions to form channel hole arrays.

A selective epitaxial growth (SEG) process may be performed to form an epitaxial layer 350 partially filling the channel hole 340.

In example embodiments, the SEG process may be performed using a silicon source gas, an etching gas and a carrier gas, and thus a single crystalline silicon layer may be formed as the epitaxial layer 350.

In the SEG process, for example, silane (SiH₄) gas, disilane (Si₂H₆) gas, dichlorosilane (SiH₂Cl₂) gas, etc., may be used as the silicon source gas, for example, hydrogen chloride (HCl) gas may be used as the etching gas, and, for example, hydrogen (H₂) gas may be used as the carrier gas.

In example embodiments, a height of an upper surface of the epitaxial layer 350 may be higher than a lower surface of the first insulating interlayer 190, and may be lower than the upper surface of the second insulating interlayer 200.

Referring to FIGS. 10 and 11, after removing the first mask, a first blocking layer, a charge storage layer, a tunnel insulation layer and a first spacer layer (not shown) may be sequentially formed on a sidewall of the channel hole 340, the upper surface of the epitaxial layer 350 and the upper surface of the third insulating interlayer 330, the first spacer layer may be anisotropically etched to form a first spacer (not shown) remaining on the sidewall of the channel hole 340 only, and the tunnel insulation layer, the charge storage layer and the first blocking layer may be etched using the first spacer as an etching mask to form a tunnel insulation pattern 380, a charge storage pattern 370 and a first blocking pattern 360 each of which may have a cup-like shape with a central lower surface opened on the epitaxial layer 350 and the sidewall of the channel hole 340. During the etching process, an upper portion of the epitaxial layer 350 may be partially removed. The tunnel insulation pattern 380, the charge storage pattern 370 and the first blocking pattern 360 may form a charge storage structure 390.

After removing the first spacer, a channel layer may be formed on the exposed epitaxial layer 350, the tunnel insulation pattern 380 and the third insulating interlayer 330, and a filling layer may be formed on the channel layer to fill a remaining portion of the channel hole 340.

The channel layer may be formed to include doped or undoped polysilicon or amorphous silicon. When the channel layer is formed to include amorphous silicon, a laser epitaxial growth (LEG) process or a solid phase epitaxy (SPE) process may be further performed to transform amorphous silicon into crystalline silicon.

The filling layer and the channel layer may be planarized until the upper surface of the third insulating interlayer 330 may be exposed to form a filling pattern 410 filling the remaining portion of the channel hole 340, and the channel layer may be transformed into a channel 400.

Accordingly, the charge storage structure 390, the channel 400 and the filling pattern 410 may be sequentially stacked on the epitaxial layer 350 in the channel hole 340. The charge storage structure 390 may be formed to have a cup-like shape of which a central lower surface is opened, the channel 400 may be formed to have a cup-like shape, and the filling pattern 410 may be formed to have a pillar shape.

According as the channel holes 340 for forming the channel 400 form the channel hole array, the channel 400 may also form a channel array corresponding thereto.

An upper portion of a first structure including the filling pattern 410, the channel 400, and the charge storage structure 390 may be removed to form a trench (not shown), and a capping pattern 420 may be formed to fill the trench.

Specifically, after the upper portion of the first structure is removed by an etch back process to form the trench, a capping layer may be formed on the first structure and the third insulating interlayer 330 to fill the trench, and an upper portion of the capping layer may be planarized until the upper surface of the third insulating interlayer 330 may be exposed to form the capping pattern 420. In example embodiments, the capping layer may be formed to include doped or undoped polysilicon or amorphous silicon, and when the capping layer is formed to include amorphous silicon, a crystallization process may be further performed.

The first structure, the epitaxial layer 350 and the capping pattern 420 in the channel hole 340 may be defined as a second structure.

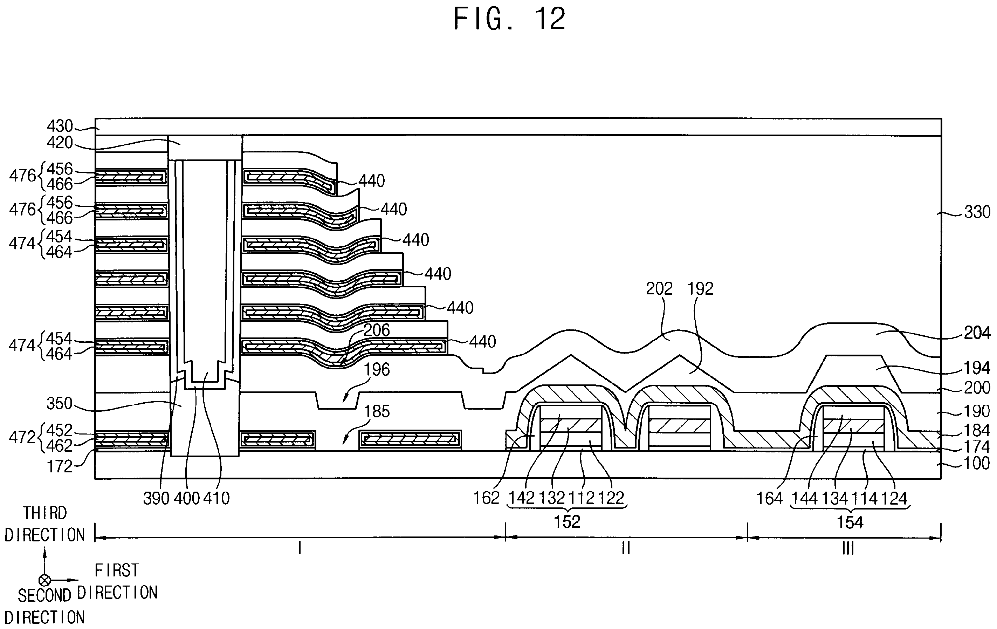

Referring to FIG. 12, a fourth insulating interlayer 430 may be formed on the third insulating interlayer 330 and the capping pattern 420. After forming a second mask (not shown) on the fourth insulating interlayer 430, a second opening (not shown) may be formed through the fourth insulating interlayer 430, the third insulation patterns 325, the second sacrificial patterns 315, the second insulating interlayer 200, the first insulating interlayer 190, the first sacrificial pattern 182, and the first insulation pattern 172 to expose the upper surface of the substrate 100 using the second mask as an etching mask. The fourth insulating interlayer 430 may include an oxide, e.g., silicon oxide, and thus may be merged with the underlying third insulating interlayer 330.

In example embodiments, the second opening may be formed to extend in the first direction on the first region I of the substrate 100, and a plurality of second openings may be formed in the second direction.

After removing the second mask, the first and second sacrificial patterns 182 and 315 exposed by the second opening may be removed to form a gap (not shown) between the third insulation patterns 325 at a plurality of levels, between the second insulating interlayer 200 and a lowermost one of the third insulation patterns 325, and between the first insulating interlayer 190 and the first insulation pattern 172, and a portion of an outer sidewall of the first blocking pattern 360 and a portion of a sidewall of the epitaxial layer 350 may be exposed by the gap. In example embodiments, the first and second sacrificial patterns 182 and 315 exposed by the second opening may be removed by a wet etching process using an etchant including phosphoric acid or sulfuric acid.

A second blocking layer 440 may be formed on the exposed outer sidewall of the first blocking pattern 360, the exposed sidewall of the epitaxial layer 350, an inner wall of the gap, surfaces of the first and third insulation patterns 172 and 325, the exposed upper surface of the substrate 100, and an upper surface of the fourth insulating interlayer 430, a gate barrier layer may be formed on the second blocking layer 440, and a gate conductive layer may be formed on the gate barrier layer to fill a remaining portion of the gap.

The gate conductive layer and the gate barrier layer may be partially removed to form a gate conductive pattern and a gate barrier pattern, respectively, in the gap, which may form a cell gate electrode. In example embodiments, the gate conductive layer and the gate barrier layer may be partially removed by a wet etching process.

In example embodiments, the cell gate electrode may extend in the first direction, and a plurality of cell gate electrodes may be formed in the second direction. That is, the plurality of the cell gate electrodes each of which may extend in the first direction may be spaced apart from each other in the second direction by the second opening.

The cell gate electrode may include third to fifth gate electrodes 472, 474 and 476 sequentially stacked in the third direction. The third gate electrode may be formed at a lowermost level, each of the fourth and fifth gate electrodes 474 and 476 may be formed on the third gate electrode 472 at one or a plurality of levels, respectively. In example embodiments, the fifth gate electrode 476 may be formed at an uppermost level and a level thereunder, and the fourth gate electrode 474 may be formed at a plurality of levels between the third gate electrode 472 and the fifth gate electrodes 476.

Impurities may be implanted into an upper portion of the substrate 100 exposed by the second opening to form an impurity region (not shown). In example embodiments, the impurities may include an n-type impurity, e.g., phosphorus, arsenic, etc.

A second spacer layer (not shown) may be formed on the upper surface of the substrate 100 exposed by the second opening, a sidewall of the second opening and the upper surface of the fourth insulating interlayer 430, and the second spacer layer may be anisotropically etched to form a second spacer (not shown) on the sidewall of the second opening. Accordingly, a portion of the impurity region at the upper portion of the substrate 100 may be exposed.

A common source line (CSL) (not shown) may be formed on the exposed impurity region to fill a remaining portion of the second opening. In example embodiments, a conductive layer may be formed on the exposed upper surface of the impurity region, the second spacer and the fourth insulating interlayer 430 to fill the second opening, and an upper portion of the conductive layer may be planarized until the upper surface of the fourth insulating interlayer may be exposed to form the CSL. During the planarization process, a portion of the second blocking layer 440 on the upper surface of the fourth insulating interlayer 430 may be also removed. The CSL may be formed in the second opening, and may contact the upper surface of the impurity region.

Referring again to FIGS. 1A and 1B, after forming a fifth insulating interlayer 480 on the fourth insulating interlayer 430, the CSL, the second spacer and the second blocking layer 440, a first contact plug 492 may be formed through the fourth and fifth insulating interlayers 430 and 480 to contact an upper surface of the capping pattern 420. A second contact plug 494 may be formed through the third to fifth insulating interlayers 330, 430 and 480, the third insulation pattern 325, the second blocking layer 440 and the fourth and fifth gate barrier patterns 454 and 456 to contact one of upper surfaces of fourth and fifth gate conductive patterns 464 and 466, or may be formed through the first to fifth insulating interlayers 190, 200, 330, 430 and 480, the second blocking layer 440 and the third gate barrier pattern 452 to contact an upper surface of the third gate conductive pattern 462.

Also, a third contact plug 496 may be formed through the first to fifth insulating interlayers 190, 200, 330, 430 and 480, the etch stop pattern 184, the second insulation pattern 174 and the first gate mask 142 to contact an upper surface of the first metal pattern 132, and a fourth contact plug 498 may be formed through the first to fifth insulating interlayers 190, 200, 330, 430 and 480, the etch stop pattern 184 and the second insulation pattern 174 to contact the upper surface of the substrate 100.

Each of the second contact plugs 494 may be formed on each of the pads having a staircase shape. That is, each of the second contact plugs 494 may be formed on a portion of each pad not covered by higher pads.

A sixth insulating interlayer 500 may be formed on the fifth insulating interlayer 480 and the first to fourth contact plugs 492, 494, 496 and 498, and first to fourth wirings 512, 514, 516 and 518 may be formed through the sixth insulating interlayer 500 to contact upper surfaces of the first to fourth contact plugs 492, 494, 496 and 498, respectively, which may complete the fabrication of the vertical memory device. In example embodiments, the first wiring 512 may extend in the second direction, and may serve as a bit line of the vertical memory device.

As described above, in the method of manufacturing the vertical memory device, even if the upper surfaces of the first and second insulating interlayers 190 and 200 covering the first and second gate structure 152 and 154 on the second and third regions II and III of the substrate 100 may not be flat due to the first and second gate structures 152 and 154, a planarization process for planarizing the upper surfaces of the first and second insulating interlayers 190 and 200 may not be performed immediately. On the other hand, after forming the third insulating interlayer 330 on the second insulating interlayer 200 to cover the mold on the first region I of the substrate 100, the planarization process may be performed.

Accordingly, the planarization process may be performed only after forming the first and second sacrificial patterns 182 and 315 included in the mold for forming the cell gate electrodes, that is, the third to fifth gate electrodes 472, 474 and 476, so that the degradation of characteristics by the planarization process, for example, scratches on the layers on the first region I of the substrate 100, may be prevented.

The angular protrusion and depression shape of the second concave portion 206 of the upper surface of the second insulating interlayer 200, which may be formed due to the first opening 185 on the first region I of the substrate 100, may be transformed into a rounded protrusion and depression shape by a wet etching process, and thus the degradation of characteristics due to the concentration of electric field may be alleviated.

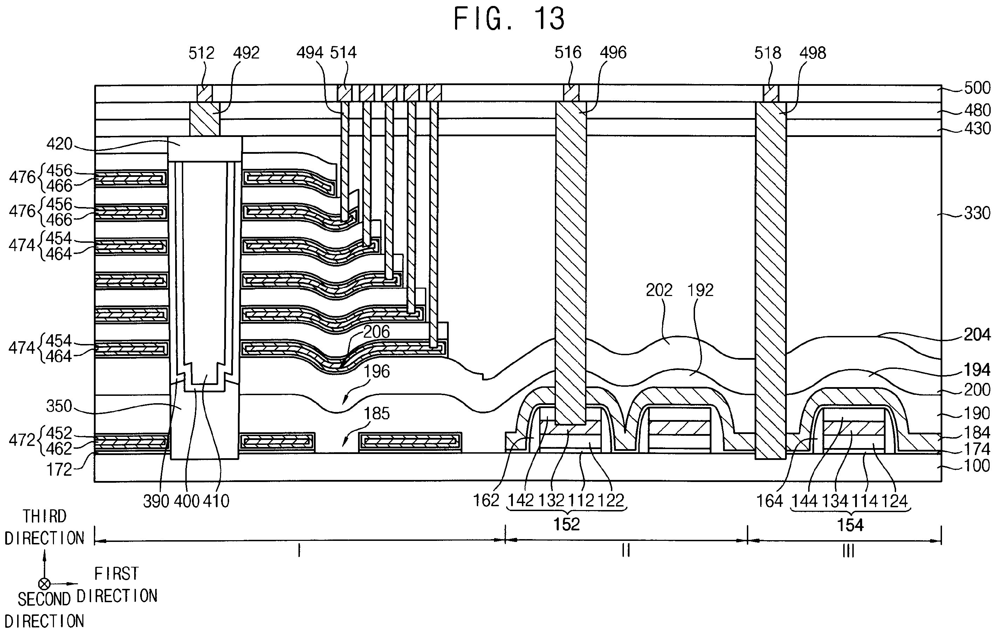

FIG. 13 is a cross-sectional view illustrating a vertical memory device in accordance with example embodiments.

The vertical memory device may be the substantially same as or similar to the vertical memory device described with reference to FIGS. 1A and 1B, except for the shape of the upper surface of the first insulating interlayer 190. Accordingly, like reference numerals refer to like elements, and detailed descriptions thereon are omitted herein.

Referring to FIG. 13, portions of the first insulating interlayer 190 on the first and second gate structures 152 and 154 on the second and third regions II and III of the substrate 100 may relatively protrude upwardly in comparison with other portions thereof.

However, unlike the first insulating interlayer 190 described in FIG. 1A, an upper surface of the first insulating interlayer 190 described in FIG. 13 may have a smoothly curved shape instead of an angular protrusion and depression shape. For example, upper surfaces of the first and second portions 192 and 194, which may overlap the first and second gate structures 152 and 154 on the first insulating interlayer 190 in the third direction, may have a cross-section in the first direction having a rounded curved shape corresponding to the shape of a portion of a polygon.

The first concave portion 196 on the upper surface of the first insulating interlayer 190 corresponding to the first opening 185 may also have a cross-section having a rounded curved shape corresponding to the shape of a portion of a polygon.

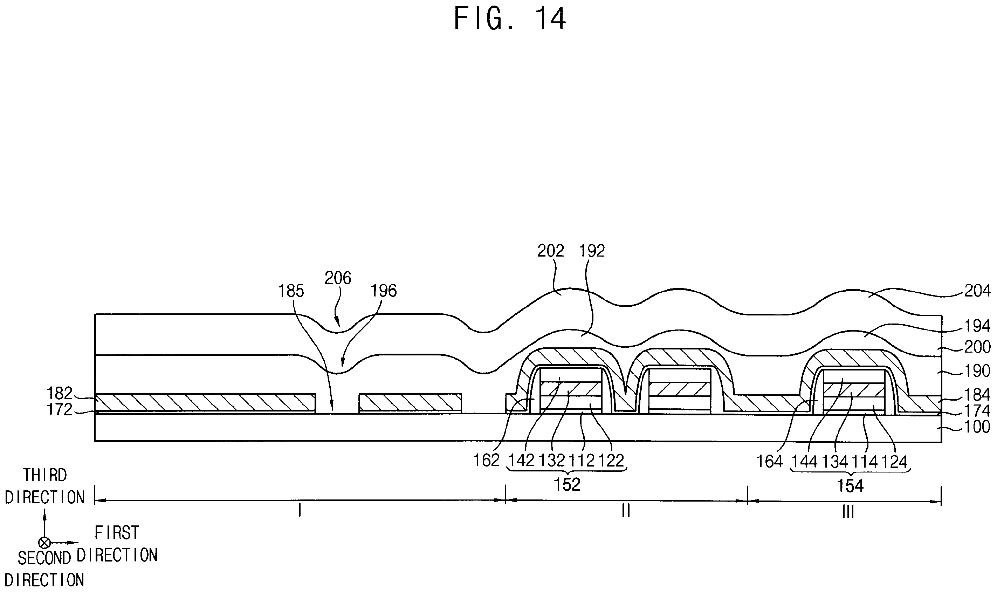

FIG. 14 is a cross-sectional view illustrating a method of manufacturing a vertical memory device in accordance with example embodiments.

This method of manufacturing the vertical memory device may include processes substantially same as or similar to the processes described with reference to FIGS. 2 to 12 and FIGS. 1A and 1B, so that detailed descriptions thereon are omitted herein.

Referring to FIG. 14, processes substantially same as or similar to the processes described with reference to FIGS. 2 to 4 may be performed.

However, before forming the second insulating interlayer 200 on the first insulating interlayer 190, an additional etching process may be performed on the upper portion of the first insulating interlayer 190 so that the angular protrusion and depression shape may be transformed into a rounded protrusion and depression shape.

In example embodiments, the etching process may include a wet etching process.

Processes substantially same as or similar to the processes described with reference to FIGS. 5 to 12 and FIGS. 1A and 1B may be performed to complete the fabrication of the vertical memory device.

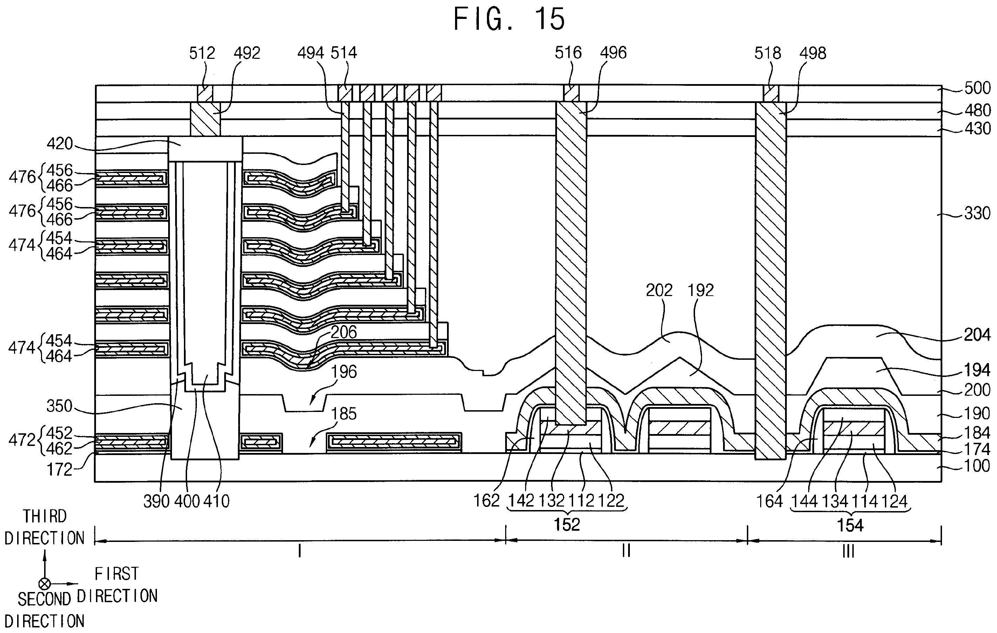

FIG. 15 is a cross-sectional view illustrating a vertical memory device in accordance with example embodiments.

This vertical memory device may be substantially same as or similar to the vertical memory device described in FIGS. 1A and 1B, except for the positions of the first opening, and the first and second concave portions. Accordingly, like reference numerals refer to like elements, and detailed descriptions thereon are omitted herein.

Referring to FIG. 15, the first opening 185 partially exposing the upper surface of the substrate 100 may be formed through the third gate electrode 472 and the underlying first insulation pattern 172, which may be closer to a central portion rather than an edge portion of the first region I of the substrate 100, when compared to the first opening described in FIG. 1A.

Accordingly, the first and second concave portions 196 and 206 may be also formed to be closer to the central portion of the first region I of the substrate 100 correspondingly to the first opening 185, and each of the pads contacting the second contact plugs 294 may have a flat upper surface.

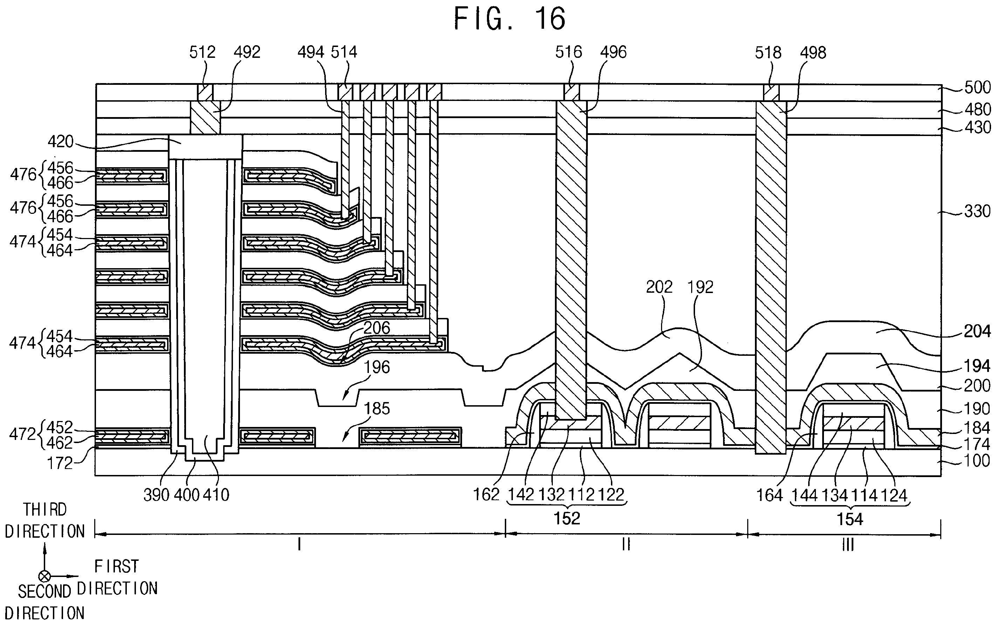

FIG. 16 is a cross-sectional view illustrating a vertical memory device in accordance with example embodiments. This vertical memory device may be substantially the same as or similar to the vertical memory device described in FIGS. 1A and 1B, except for the epitaxial layer, the channel and the charge storage structure. Accordingly, like reference numerals refer to like elements, and detailed descriptions thereon are omitted herein.

Referring to FIG. 16, the vertical memory device may not include the epitaxial layer 350 described in FIGS. 1A and 1B. Accordingly, the channel 400 may be formed to have a cup-like shape contacting the upper surface of the substrate 100, and the charge storage structure 390 may be formed to have a cup-like shape of which a central lower surface is opened. The charge storage structure 390 may cover an outer sidewall of the channel 400, and may contact the upper surface of the substrate 100.

## Claims

1. A vertical memory device, comprising:
a gate structure (152) including a first gate electrode (122, 132) on a peripheral circuit region (II, III) of a substrate (100), the substrate (100) containing a cell region (I) and the peripheral circuit region (II, III);
a plurality of second gate electrodes (124, 134) sequentially stacked on the cell region (I) of the substrate (100), the plurality of second gate electrodes (124, 134) spaced apart from each other in a vertical direction to an upper surface of the substrate (100);
a channel (400) extending in the vertical direction on the cell region (I) of the substrate (100) and extending through at least one of the second gate electrodes (124, 134); and
a first insulating interlayer (190) covering the gate structure (152) on the peripheral circuit region (II, III) of the substrate (100), a cross-section in one direction of an upper surface of a portion of the first insulating interlayer (190) overlapping the gate structure (152) in the vertical direction having a shape of a portion of a polygon,
wherein the second gate electrodes (124, 134) include third to fifth gate electrodes (472, 474, 476) sequentially stacked on the substrate (100) in the vertical direction, and
wherein the first insulating interlayer (190) is also on the cell region (I) of the substrate (100) to cover the third gate electrode (472),
wherein
a second insulating interlayer (200) between the first insulating interlayer (190) and the third gate electrode (472),
**characterized in that**
an upper surface of a portion of each of the first and second insulating interlayers (190; 200) has a concave shape on the cell region (I) of the substrate (100).

2. The vertical memory device of claim 1, further comprising:
a second insulating interlayer (200) on the first insulating interlayer (190),
wherein a cross-section in the direction of an upper surface of a portion of the second insulating interlayer (200) has a curved shape corresponding to that of the upper surface of the portion of the first insulating interlayer (190).

3. The vertical memory device of claim 2, wherein the first and second insulating interlayers (190; 200) include high density plasma (HDP) oxide and TEOS, respectively.

4. The vertical memory device of claim 2, further comprising:
a third insulating interlayer (330) on the second insulating interlayer (200),
wherein the third insulating interlayer (330) has a flat upper surface.

5. The vertical memory device of claim 4, wherein the second and third insulating interlayers (200; 330) include substantially the same material.

6. The vertical memory device of claim 1, wherein the first and second insulating interlayers (190; 200) include high density plasma (HDP) oxide and TEOS, respectively.

7. The vertical memory device of claim 1, wherein a concave portion of the upper surface of the first insulating interlayer (190) has a cross-section in the direction having a shape of a portion of a polygon, and a concave portion of the upper surface of the second insulating interlayer (200) has a cross-section in the direction with a curved shape corresponding to the shape of the cross-section of the concave portion of the upper surface of the first insulating interlayer (190).

8. The vertical memory device of claim 1, wherein one or ones of the fourth gate electrodes (474) have a concave portion.

9. The vertical memory device of claim 1, wherein the third, the fourth and the fifth gate electrodes (472, 474, 476) serve as a ground selection line (GSL), a word line, and a string selection line (SSL), respectively.

10. The vertical memory device of claim 1, wherein the first insulating interlayer (190) covers a lowermost second gate electrode (124, 134) among the second gate electrodes (124, 134), and
wherein an upper surface of at least a portion of the first insulating interlayer (190) on the peripheral circuit region (II, III) of the substrate (100) has an angular protrusion and depression shape.

11. The vertical memory device of claim 10, further comprising:
a second insulating interlayer (200) on the first insulating interlayer (190),
wherein an upper surface of the portion of the second insulating interlayer (200) on the peripheral circuit region (II, III) of the substrate (100) has a rounded protrusion and depression shape corresponding to the shape of the upper surface of the at least a portion of the first insulating interlayer (190).

12. The vertical memory device of claim 11, further comprising: a third insulating interlayer (330) on the second insulating interlayer (200) on the peripheral circuit region (II, III) of the substrate (100),
wherein the third insulating interlayer has a flat upper surface.

## Patentansprüche

1. Vertikale Speichervorrichtung, umfassend:
eine Gatestruktur (152), die eine erste Gateelektrode (122, 132) auf einem Peripherieschaltungsbereich (II, III) eines Substrats (100) umfasst, wobei das Substrat (100) einen Zellbereich (I) und den Peripherieschaltungsbereich (II, III) enthält;
eine Mehrzahl zweiter Gateelektroden (124, 134), die nacheinander auf dem Zellbereich (I) des Substrats (100) gestapelt sind, wobei die Mehrzahl zweiter Gateelektroden (124, 134) in einer vertikalen Richtung bezüglich einer Oberseite des Substrats (100) voneinander beabstandet sind;
einen Kanal (400), der sich in der vertikalen Richtung auf dem Zellbereich (I) des Substrats (100) erstreckt und sich durch mindestens eine der zweiten Gateelektroden (124, 134) hindurch erstreckt; und
eine erste isolierende Zwischenschicht (190), welche die Gatestruktur (152) auf dem Peripherieschaltungsbereich (II, III) des Substrats (100) bedeckt, wobei ein Querschnitt in einer Richtung einer Oberseite eines Abschnitts der ersten isolierenden Zwischenschicht (190), der die Gatestruktur (152) in der vertikalen Richtung überlappt, die Form eines Teils eines Polygons aufweist,
wobei die zweiten Gateelektroden (124, 134) dritte bis fünfte Gateelektroden (472, 474, 476) umfassen, die nacheinander in der vertikalen Richtung auf dem Substrat (100) gestapelt sind, und
wobei die erste isolierende Zwischenschicht (190) ferner auf dem Zellbereich (I) des Substrats (100) angeordnet ist, um die dritte Gateelektrode (472) zu bedecken,
wobei eine zweite isolierende Zwischenschicht (200) zwischen der ersten isolierenden Zwischenschicht (190) und der dritten Gateelektrode (472) angeordnet ist,
**dadurch gekennzeichnet, dass** eine Oberseite eines Abschnitts jeder der ersten und zweiten isolierenden Zwischenschichten (190; 200) auf dem Zellbereich (I) des Substrats (100) eine konkave Form aufweist.

2. Vertikale Speichervorrichtung nach Anspruch 1, ferner umfassend:
eine zweite isolierende Zwischenschicht (200) auf der ersten isolierenden Zwischenschicht (190),
wobei ein Querschnitt in der Richtung einer Oberseite eines Abschnitts der zweiten isolierenden Zwischenschicht (200) eine gekrümmte Form aufweist, die der Form der Oberseite des Abschnitts der ersten isolierenden Zwischenschicht (190) entspricht.

3. Vertikale Speichervorrichtung nach Anspruch 2, wobei die erste und die zweite isolierende Zwischenschicht (190; 200) Hochdichteplasma-(HDP)-Oxid beziehungsweise TEOS umfassen.

4. Vertikale Speichervorrichtung nach Anspruch 2, ferner umfassend:
eine dritte isolierende Zwischenschicht (330) auf der zweiten isolierenden Zwischenschicht (200),
wobei die dritte isolierende Zwischenschicht (330) eine ebene Oberseite aufweist.

5. Vertikale Speichervorrichtung nach Anspruch 4, wobei die zweite und die dritte isolierende Zwischenschicht (200; 330) im Wesentlichen dasselbe Material umfassen.

6. Vertikale Speichervorrichtung nach Anspruch 1, wobei die erste und die zweite isolierende Zwischenschicht (190; 200) Hochdichteplasma-(HDP)-Oxid beziehungsweise TEOS umfassen.

7. Vertikale Speichervorrichtung nach Anspruch 1, wobei ein konkaver Abschnitt der Oberseite der ersten isolierenden Zwischenschicht (190) einen Querschnitt in der Richtung mit der Form eines Teils eines Polygons aufweist und ein konkaver Abschnitt der Oberseite der zweiten isolierenden Zwischenschicht (200) einen Querschnitt in der Richtung mit einer gekrümmten Form aufweist, die der Form des Querschnitts des konkaven Abschnitts der Oberseite der ersten isolierenden Zwischenschicht (190) entspricht.

8. Vertikale Speichervorrichtung nach Anspruch 1, wobei eine oder mehrere der vierten Gateelektroden (474) einen konkaven Abschnitt aufweisen.

9. Vertikale Speichervorrichtung nach Anspruch 1, wobei die dritte, die vierte und die fünfte Gateelektrode (472, 474, 476) jeweils als Masse-Auswahlleitung (GSL), Wortleitung beziehungsweise Strang-Auswahlleitung (SSL) dienen.

10. Vertikale Speichervorrichtung nach Anspruch 1, wobei die erste isolierende Zwischenschicht (190) eine unterste zweite Gateelektrode (124, 134) unter den zweiten Gateelektroden (124, 134) bedeckt, und
wobei eine Oberseite mindestens eines Abschnitts der ersten isolierenden Zwischenschicht (190) auf dem Peripherieschaltungsbereich (II, III) des Substrats (100) eine winklige Vorsprungs- und Vertiefungsform aufweist.

11. Vertikale Speichervorrichtung nach Anspruch 10, ferner umfassend:
eine zweite isolierende Zwischenschicht (200) auf der ersten isolierenden Zwischenschicht (190), wobei eine Oberseite des Abschnitts der zweiten isolierenden Zwischenschicht (200) auf dem Peripherieschaltungsbereich (II, III) des Substrats (100) eine abgerundete Vorsprungs- und Vertiefungsform aufweist, die der Form der Oberseite des mindestens einen Abschnitts der ersten isolierenden Zwischenschicht (190) entspricht.

12. Vertikale Speichervorrichtung nach Anspruch 11, ferner umfassend:
eine dritte isolierende Zwischenschicht (330) auf der zweiten isolierenden Zwischenschicht (200) auf dem Peripherieschaltungsbereich (II, III) des Substrats (100),
wobei die dritte isolierende Zwischenschicht eine ebene Oberseite aufweist.

## Revendications

1. Dispositif de mémoire verticale, comprenant :
une structure de grille (152) comprenant une première électrode de grille (122, 132) sur une région de circuit périphérique (II, III) d'un substrat (100), le substrat (100) contenant une région de cellules (I) et la région de circuit périphérique (II, III) ;
une pluralité de deuxièmes électrodes de grille (124, 134) empilées successivement sur la région de cellules (I) du substrat (100), la pluralité de deuxièmes électrodes de grille (124, 134) étant espacées les unes des autres dans une direction verticale par rapport à une surface supérieure du substrat (100) ;
un canal (400) s'étendant dans la direction verticale sur la région de cellules (I) du substrat (100) et traversant au moins une des deuxièmes électrodes de grille (124, 134) ; et
une première couche intercalaire isolante (190) recouvrant la structure de grille (152) sur la région de circuit périphérique (II, III) du substrat (100), une coupe transversale, dans une direction d'une surface supérieure d'une partie de la première couche intercalaire isolante (190) chevauchant la structure de grille (152) dans la direction verticale, ayant la forme d'une partie d'un polygone,
dans lequel les deuxièmes électrodes de grille (124, 134) comprennent des troisième à cinquième électrodes de grille (472, 474, 476) empilées successivement sur le substrat (100) dans la direction verticale, et
dans lequel la première couche intercalaire isolante (190) est également située sur la région de cellules (I) du substrat (100) de manière à recouvrir la troisième électrode de grille (472),
dans lequel une deuxième couche intercalaire isolante (200) est disposée entre la première couche intercalaire isolante (190) et la troisième électrode de grille (472),
**caractérisé en ce qu'**une surface supérieure d'une partie de chacune des première et deuxième couches intercalaires isolantes (190 ; 200) présente une forme concave sur la région de cellules (I) du substrat (100).

2. Dispositif de mémoire verticale selon la revendication 1, comprenant en outre :
une deuxième couche intercalaire isolante (200) sur la première couche intercalaire isolante (190),
dans lequel une coupe transversale, dans la direction, d'une surface supérieure d'une partie de la deuxième couche intercalaire isolante (200) présente une forme incurvée correspondant à la forme de la surface supérieure de la partie de la première couche intercalaire isolante (190).

3. Dispositif de mémoire verticale selon la revendication 2,
dans lequel les première et deuxième couches intercalaires isolantes (190 ; 200) comprennent respectivement de l'oxyde de plasma haute densité (HDP) et du TEOS.

4. Dispositif de mémoire verticale selon la revendication 2, comprenant en outre :
une troisième couche intercalaire isolante (330) sur la deuxième couche intercalaire isolante (200),
dans lequel la troisième couche intercalaire isolante (330) présente une surface supérieure plane.

5. Dispositif de mémoire verticale selon la revendication 4, dans lequel les deuxième et troisième couches intercalaires isolantes (200 ; 330) comprennent sensiblement le même matériau.

6. Dispositif de mémoire verticale selon la revendication 1, dans lequel les première et deuxième couches intercalaires isolantes (190 ; 200) comprennent respectivement de l'oxyde de plasma haute densité (HDP) et du TEOS.

7. Dispositif de mémoire verticale selon la revendication 1, dans lequel une partie concave de la surface supérieure de la première couche intercalaire isolante (190) présente une coupe transversale dans la direction ayant la forme d'une partie d'un polygone, et une partie concave de la surface supérieure de la deuxième couche intercalaire isolante (200) présente une coupe transversale dans la direction ayant une forme incurvée correspondant à la forme de la coupe transversale de la partie concave de la surface supérieure de la première couche intercalaire isolante (190).

8. Dispositif de mémoire verticale selon la revendication 1, dans lequel une ou plusieurs des quatrièmes électrodes de grille (474) présentent une partie concave.

9. Dispositif de mémoire verticale selon la revendication 1, dans lequel les troisième, quatrième et cinquième électrodes de grille (472, 474, 476) servent respectivement de ligne de sélection de masse (GSL), de ligne de mots et de ligne de sélection de chaîne (SSL).

10. Dispositif de mémoire verticale selon la revendication 1, dans lequel la première couche intercalaire isolante (190) recouvre une deuxième électrode de grille (124, 134) la plus inférieure parmi les deuxièmes électrodes de grille (124, 134), et
dans lequel une surface supérieure d'au moins une partie de la première couche intercalaire isolante (190) sur la région de circuit périphérique (II, III) du substrat (100) présente une forme anguleuse de saillie et de creux.

11. Dispositif de mémoire verticale selon la revendication 10, comprenant en outre :
une deuxième couche intercalaire isolante (200) sur la première couche intercalaire isolante (190),
dans lequel une surface supérieure de la partie de la deuxième couche intercalaire isolante (200) sur la région de circuit périphérique (II, III) du substrat (100) présente une forme arrondie de saillie et de creux correspondant à la forme de la surface supérieure de ladite au moins une partie de la première couche intercalaire isolante (190).

12. Dispositif de mémoire verticale selon la revendication 11, comprenant en outre :
une troisième couche intercalaire isolante (330) sur la deuxième couche intercalaire isolante (200) sur la région de circuit périphérique (II, III) du substrat (100),
dans lequel la troisième couche intercalaire isolante présente une surface supérieure plane.
